# EUROPEAN PATENT SPECIFICATION

(11) **EP 0 401 019 B1**
(45) Date of publication and mention of the grant of the patent: **14.09.1994**
(21) Application number: 90305945.9
(22) Date of filing: 31.05.1990
(51) Int. Cl.: H04B 1/38

(54) **Structure of a duplexer for radio equipment**
Duplexerstruktur zur Funkausrüstung
Structure d'un duplexeur pour équipement radio

(30) Priority: 02.06.1989 JP 63986/89
(43) Date of publication of application: 05.12.1990
(73) Proprietor: NEC CORPORATION, Tokyo (JP)
(72) Inventor: Ueda, Hideki, Minato-ku, Tokyo (JP)
(74) Representative: Orchard, Oliver John

(56) References cited:
- US-A- 4 462 098
- US-A- 4 520 474
- PATENT ABSTRACTS OF JAPAN (E-190)2 August 1983

## Description

### BACKGROUND OF THE INVENTION

The present invention relates to a duplexer for duplex radio equipment and, more particularly, to a segmentalized duplexer for duplex radio equipment.

A duplexer is one of major component parts of radio equipment and selectively serves a transmitting function and a receiving function. The transmitting function is implemented by a transmitter section, a transmit filter, and a matching circuit to which a transmit signal is applied from the transmitter section via the transmit filter. The transmit signal is fed from the matching circuit to an antenna to be radiated as a transmit signal wave. The receiving function is implemented by a receive filter, a receiver section, and the matching circuit which feeds a received wave coming in through the antenna to the receiver section via the receive filter. It has been customary to mount all the circuit sections of the duplexer including the transmitter section, receiver section, transmit and receive filters and matching circuit on a single printed circuit board. Such a configuration has the following problems.
(1) Freedom available in mounting the various parts and elements is severely limited. This is especially problematic when it comes to portable radio equipment which need extremely dense arrangements.
(2) It is difficult to examine the characteristics of the transmitter section only or those of the receiver section only. This impedes maintenance which is needed in the event of the failure of the equipment
(3) The specifications of the transmit filter or those of the receive filter are usually changed by redesigning the matching circuit. The matching circuit, therefore, cannot be redesigned unless the whole printed circuit is redesigned.

### SUMMARY OF THE INVENTION

It is therefore an object of the present invention to provide a structure of a duplexer for radio equipment which promotes efficient mounting and facilitates maintenance and design changes.

A structure of a duplexer for duplex radio equipment has a transmission circuit board loaded with a transmitter section and a transmit filter for filtering a high frequency signal fed from the transmitter section. A reception circuit board physically independent of the transmission circuit board is loaded with a receive filter for filtering a received high frequency signal and a receiver section for receiving the high frequency signal from the receive filter. A connection circuit board mechanically connects the transmission circuit board and reception circuit board and is loaded with a matching circuit coupled to the transmit and receive filters and an antenna for matching the impedance thereof. Connectors electrically interconnect the transmit filter and receive filter to the matching circuit.

### BRIEF DESCRIPTION OF THE DRAWINGS

The above and other objects, features and advantages of the present invention will become more apparent from the following detailed description taken with the accompanying drawings in which:
Fig. 1 is a perspective view of a duplexer embodying the present invention; and
Fig. 2 is a block diagram schematically showing electric circuitry of the duplexer shown in Fig. 1.

### DESCRIPTION OF THE PREFERRED EMBODIMENT

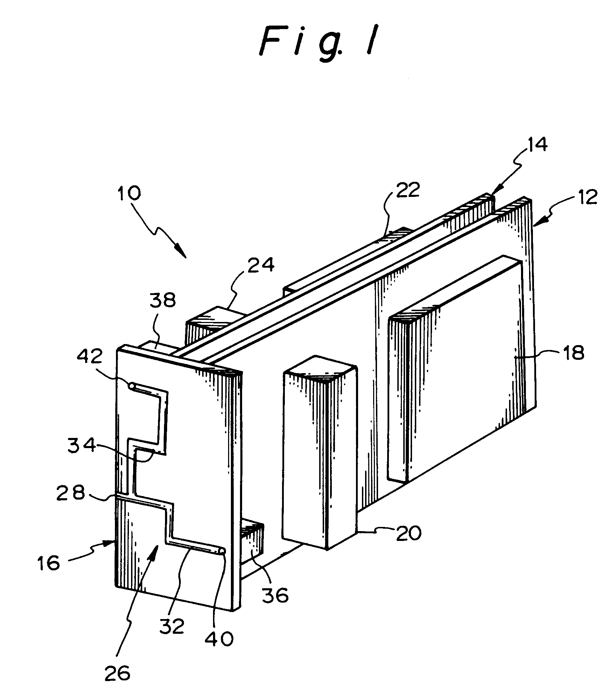

Referring to Fig. 1 of the drawings, a duplexer for radio equipment embodying the present invention is shown and generally designated by the reference numeral 10. As shown, the duplexer 10 is generally made up of a transmission circuit board 12, a reception circuit board 14, and a connection circuit board 16 which are physically independent of one another. The connection circuit board 16 connects the transmission and reception circuit boards 12 and 14 generally in a U configuration. The transmission circuit board 12 has a transmitter section 18 and a transmit filter 20 and outputs a high frequency signal to be transmitted. The transmit filter 20 filters out noise from the the output signal of the transmitter section 18 so as to pass only the predetermined high frequency signal.

The reception circuit board 14 has a receiver section 22 and a receive filter 24. The receiver section 22 receives a high frequency signal from a remote station, not shown, while the receive filter 24 passes only the predetermined high frequency signal to the receiver section 22 by removing noise from the received signal. The reception circuit board 14 has substantially the same dimensions as the transmission circuit board 12. The transmission and reception circuit boards 12 and 14 are arranged back-to-back and in parallel to each other.

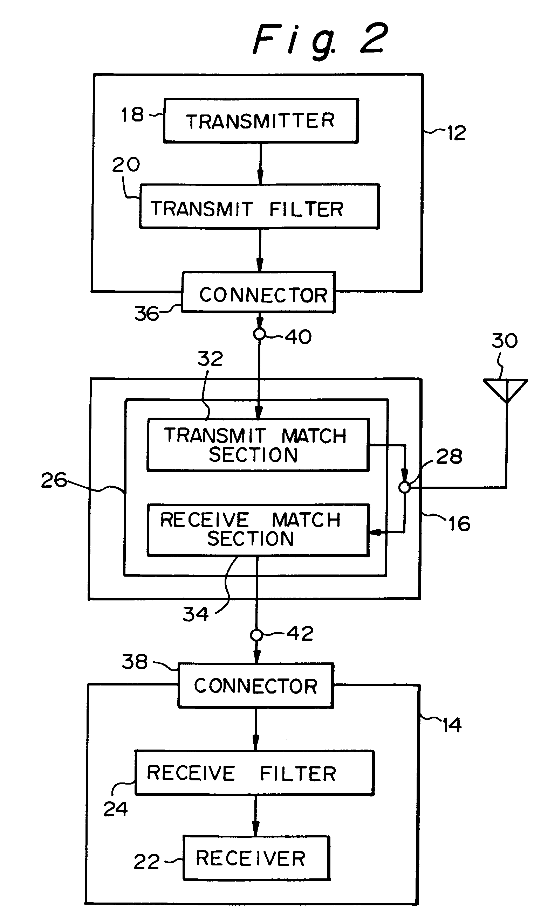

As shown in Fig. 2, the connection circuit board 16 has a matching circuit 26 which is interconnected to an antenna 30 via an antenna terminal 28. The matching circuit 26 is constituted by a transmit matching section 32 and a receive matching section 34. The transmit matching section 32 matches the output impedance of transmit filter 20 and the impedance of antenna 30 and receive side (14) as viewed from the antenna terminal 28. In other words, a combination of the transmit filter 20 and transmit matching section 32 serves to pass the transmit high frequency signal from the transmit section 18 and to block the other signals. As shown in Fig. 1, the transmit matching section 32 is implemented as a line of copper foil extending out from the antenna terminal 28. The transmit matching section 32 has the same impedance as the transmit filter 20. The receive matching section 34 matches the input impedance of receive filter 24 and transmit side (12) as viewed from the antenna terminal 28. In other words, a combination of the receive filter 24 and receive matching section 34 serves to pass the receive high frequency signal from the antenna 30 and block the other signals. The receive matching section 34, like the transmit matching section 32, is implemented as a line of copper foil extending out from the antenna terminal 28 and has the same impedance as the receive filter 24. The connection circuit board 16 is affixed at its back to the adjoining ends of the parallel transmission and reception circuit boards 12 and 14, thereby supporting the two boards 12 and 14 generally in a U configuration.

Connectors 36 and 38 adapted for high frequency electrically interconnect respectively the transmission circuit board 12 and the reception circuit board 14 to the connection circuit board 16. Specifically, the connector 36 sets up electrical connection of the output side of the transmit filter 20 to the transmit end 40 of the transmit matching section 32, while the connector 38 sets up electrical connection of the input side of the receive filter 24 to the receive end 42 of the receive matching section 34.

In operation, to transmit a signal to a remote station, the transmitter section 18 of the transmission circuit board 12 produces a predetermined high frequency signal. The high frequency signal is routed through the transmit filter 20, connector 36 and transmit end 40 to the transmit matching section 32. The output of the matching section 32 is fed to the antenna 30 via the antenna terminal 28 and thereby radiated as a high frequency signal wave. A high frequency signal wave from a remote station comes in through the antenna 30 and is applied to the receive matching circuit 34 via the antenna terminal 28. The output of the receive matching circuit 34 is routed through the receive end 42 and connector 38 to the receive filter 24. The filtered signal from the receive filter 24 is fed to the receiver section 22.

Of course, the generally U-shaped configuration of the assembly of the three physically separate circuit boards, 12, 14 and 16 shown and described is only illustrative and may be suitably changed or modified by taking account of the positions of the connectors 36 and 38 as well as other conditions.

In summary, it will be seen that the present invention provides a duplexer having various unprecedented advantages, as enumerated below.
(1) Various components of a duplexer such as a transmitter section, receiver section, transmit filter, receive filter and matching circuit are mounted with improved efficiency. This is especially desirable for those radio equipment which need extremely dense arrangements, e. g. portable radio equipment.
(2) Since transmission, reception and connection circuit boards are physically independent of each other, the characteristics of the transmitter section and those of the receiver section can be examined independently of each other. This will facilitate maintenance when an error occurs in the equipment.
(3) The transmitter section, receiver section and matching circuit can be designed independently of one another and, therefore, the designing time is reduced.

Various modifications will become possible for those skilled in the art after receiving the teachings of the present disclosure without departing from the scope thereof.

## Claims

1. A duplexer for radio equipment, comprising:
a transmission circuit board loaded with a transmitter section and a transmit filter for filtering a high frequency signal fed from said transmitter section;
a reception circuit board physically independent of said transmission circuit board and loaded with a receive filter for filtering a received high frequency signal and a receiver section for receiving said high frequency signal from said receive filter; and
a connection circuit board mechanically connecting said transmission circuit board and said reception circuit board to each other and loaded with a matching circuit coupled to said transmit and receive filters and an antenna for matching the impedance thereof.

2. A duplexer as claimed in claim 1, further comprising connector means for electrically interconnecting said transmit filter and said receive filter to said matching circuit.

3. A duplexer as claimed in claim 1, wherein said reception circuit board and said transmission circuit board have the same shape.

4. A duplexer as claimed in claim 1, wherein said matching circuit comprises a transmit matching section and a receive matching section each being connected to an antenna terminal, said transmit matching section and said receive matching section each comprising a line of copper foil provided on said connection circuit board.

5. A duplexer as claimed in claim 1, wherein said transmission circuit board, said reception circuit board and said connection circuit board are assembled generally in a U configuration as viewed from a side.

6. A duplexer comprising:
transmitter means for generating a transmit high frequency signal;
receive means for receiving a receive high frequency signal;
antenna means for radiating said transmit high frequency signal and picking up said receive high frequency signal;
matching means coupled to said transmitter, receiver and antenna means for matching the impedance thereof;
transmit board means for loading said transmitter means thereon;
receive board means for loading said receiver means thereon; and
connect board means for loading said matching means thereon and mechanically connecting said transmit and receive board means.

7. A duplexer as claimed in claim 6, wherein said connect board means comprises means for mechanically connecting said transmit and receive board means generally in a U shape as viewed from a side.

8. A method of assembling a duplexer for duplex radio equipment, comprising the following steps of:
loading a transmit filter on a transmit board;
loading a receive filter on a receive board;
loading a matching circuit on a connect board;
electrically coupling said matching circuit to said transmit and receive filters and to an antenna, said matching circuit matching the impedance of said transmit and receive filters and said antenna; and
mechanically connecting said transmit and receive boards to said connect board.

9. A method as claimed in claim 8, wherein said connecting step comprises the step of mechanically connecting said transmit and receive boards to said connect board generally in a U shape as viewed from a side.

10. A method as claimed in claim 8, further comprising the steps of:
loading on said transmit board a transmit section coupled to said transmit filter; and
loading on said receive board a receive section coupled to said receive filter.

## Patentansprüche

1. Duplexer für eine Funkausrüstung mit:
einer Sendeschaltungsplatine, die mit einem Sendeabschnitt und einem Sendefilter zum Filtern eines dem Sendeabschnitt zugeführten Hochfrequenzsignals bestückt ist,
einer Empfangsschaltungsplatine, die von der Sendeschaltungsplatine physikalisch unabhängig ist und mit einem Empfangsfilter zum Filtern eines empfangenen Hochfrequenzsignals und einem Empfangsabschnitt zum Empfangen des Hochfrequenzsignals von dem Empfangsfilter bestückt ist, und
einer Verbindungsschaltungsplatine, die die Sendeschaltungsplatine und die Empfangsschaltungsplatine mechanisch miteinander verbindet und mit einer Anpaßschaltung bestückt ist, die mit dem Sende- und Empfangsfilter und einer Antenne zum Anpassen der Impedanz verbunden ist.

2. Duplexer nach Anspruch 1, ferner mit einer Verbindungseinrichtung zum elektrischen Verbinden des Sendefilters und des Empfangsfilter mit der Anpaßschaltung.

3. Duplexer nach Anspruch 1, wobei die Empfangsschaltungsplatine und die Sendeschaltungsplatine die gleiche Form haben.

4. Duplexer nach Anspruch 1, wobei die Anpaßschaltung einen Sendeanpaßabschnitt und einen Empfangsanpaßabschnitt aufweist, die jeweils mit einem Antennenanschluß verbunden sind, der Sendeanpaßabschnitt und der Empfangsanpaßabschnitt jeweils eine Leitung aus Kupferfolie aufweist, die auf der Verbindungsschaltungsplatine vorgesehen ist.

5. Duplexer nach Anspruch 1, wobei die Sendeschaltungsplatine, die Empfangsschaltungsplatine und die Verbindungsschaltungsplatine von der Seite gesehen im wesentlichen in einer U-Form zusammengesetzt sind.

6. Duplexer mit:
einer Sendeeinrichtung zum Erzeugen eines Sendehochfrequenzsignals,
einer Empfangseinrichtung zum Empfangen eines Empfangshochfrequenzsignals,
einer Antenneneinrichtung zum Abstrahlen des Sendehochfrequenzsignals und Aufnehmen des Empfangshochfrequenzsignals,
einer Anpaßschaltung, die mit der Sende-, Empfangs- und Antenneneinrichtung zum Anpassen deren Impedanz verbunden ist,
einer Sendeplatineneinrichtung, die mit der Sendeeinrichtung bestückbar ist,
einer Empfangsplatineneinrichtung, die mit der Empfangseinrichtung bestückbar ist, und
einer Verbindungsplatineneinrichtung, die mit der Anpaßeinrichtung bestückbar und mit der Sende- und Empfangsplatineneinrichtung mechanisch verbindbar ist.

7. Duplexer nach Anspruch 6, wobei die Verbindungsplatineneinrichtung Einrichtungen zum mechanischen Verbinden der Sende- und Empfangsplatineneinrichtungen in von der Seite gesehen im wesentlichen einer U-Form aufweist.

8. Verfahren zum Zusammensetzen eines Duplexers für eine Duplexfunkausrüstung, mit den folgenden Schritten:
Bestücken einer Sendeplatine mit einem Sendefilter,
Bestücken einer Empfangsplatine mit einem Empfangsfilter,
Bestücken einer Verbindungsplatine mit einer Anpaßschaltung,
Elektrisches Verbinden der Anpaßschaltung mit dem Sende- und Empfangsfilter und mit einer Antenne, wobei die Anpaßschaltung die Impedanz des Sende- und Empfangsfilters und der Antenne anpaßt, und
mechanisches Verbinden der Sende- und Empfangsplatine mit der Verbindungsplatine.

9. Verfahren nach Anspruch 8, wobei der Verbindungsschritt den Schritt des mechanischen Verbindens der Sende- und Empfangsplatine mit der Verbindungsplatine in von der Seite gesehen im wesentlichen einer U-Form aufweist.

10. Verfahren nach Anspruch 8, ferner mit den Schritten:
Bestücken der Sendeplatine mit einem Sendeabschnitt, der mit dem Sendefilter verbunden ist; und
Bestücken der Empfangsplatine mit einem Empfangsabschnitt, der mit dem Empfangsfilter verbunden ist.

## Revendications

1. Duplexeur pour équipement radio comprenant :
une carte de circuit d'émission munie d'une section émetteur et d'un filtre d'émission pour filtrer un signal haute fréquence envoyé à partir de ladite section émetteur,
une carte de circuit de réception physiquement indépendante de ladite carte de circuit d'émission, munie d'un filtre de réception pour filtrer un signal haute fréquence reçu et d'une section récepteur pour recevoir ledit signal haute fréquence provenant dudit filtre de réception, et
une carte de circuit de connexion connectant mécaniquement ladite carte de circuit d'émission et ladite carte de circuit de réception l'une à l'autre, munie d'un circuit d'adaptation couplé auxdits filtres d'émission et de réception et à une antenne pour adapter leur impédance.

2. Duplexeur selon la revendication 1, comprenant de plus un moyen de connecteur pour interconnecter électriquement ledit filtre d'émission et ledit filtre de réception audit circuit d'adaptation.

3. Duplexeur selon la revendication 1, dans lequel ladite carte de circuit de réception et ladite carte de circuit d'émission ont la même forme.

4. Duplexeur selon la revendication 1, dans lequel ledit circuit d'adaptation comprend une section d'adaptation d'émission et une section d'adaptation de réception chacune étant connectée à une borne d'antenne, ladite section d'adaptation d'émission et ladite section d'adaptation de réception comprenant chacune une ligne de feuille de cuivre prévue sur ladite carte de circuit de connexion.

5. Duplexeur selon la revendication 1, dans lequel ladite carte de circuit d'émission, ladite carte de circuit de réception et ladite carte de circuit de connexion sont assemblées généralement en une configuration en U comme observé à partir d'un côté.

6. Duplexeur comprenant :
un moyen d'émetteur pour générer un signal haute fréquence d'émission,
un moyen de récepteur pour recevoir un signal haute fréquence reçu,
un moyen d'antenne pour rayonner ledit signal haute fréquence d'émission et prélever ledit signal haute référence reçu,
un moyen d'adaptation couplé audit moyen d'émetteur, de récepteur et d'antenne pour adapter leur impédance,
un moyen de carte d'émission pour placer ledit moyen d'émetteur sur celle-ci,
un moyen de carte de réception pour placer ledit moyen de récepteur sur celle-ci, et
un moyen de carte de connexion pour placer ledit moyen d'adaptation sur celle-ci et pour connecter mécaniquement lesdits moyens de carte d'émission et de réception.

7. Duplexeur selon la revendication 6, dans lequel ledit moyen de carte de connexion comprend un moyen pour connecter mécaniquement lesdits moyens de carte d'émission et de réception généralement en une forme en U comme observé à partir d'un côté.

8. Procédé pour assembler un duplexeur pour un équipement radio duplex, comprenant les étapes suivantes consistant à :
placer un filtre d'émission sur une carte d'émission,
placer un filtre de réception sur une carte de réception,
placer un circuit d'adaptation sur une carte de connexion,
coupler électriquement ledit circuit d'adaptation auxdits filtres d'émission et de réception et à une antenne, ledit circuit d'adaptation adaptant l'impédance desdits filtres d'émission et de réception et de ladite antenne, et
connecter mécaniquement lesdites cartes d'émission et de réception à ladite carte de connexion.

9. Procédé selon la revendication 8, dans lequel l'étape de connexion comprend l'étape consistant à connecter mécaniquement lesdites cartes d'émission et de réception à ladite carte de connexion généralement en une forme en U comme observé à partir d'un côté.

10. Procédé selon la revendication 8, comprenant de plus les étapes consistant à :
placer sur ladite carte d'émission une section d'émission couplée audit filtre d'émission, et
placer sur ladite carte de réception une section de réception couplée audit filtre de réception.
